Europäisches Patentamt

European Patent Office

Office européen des brevets

(11) Numéro de publication : **0 080 953
B1**

# (12) FASCICULE DE BREVET EUROPÉEN

(45) Date de publication du fascicule du brevet :
07.05.86

(21) Numéro de dépôt : 82402179.4

(22) Date de dépôt : 30.11.82

(51) Int. Cl.⁴ : **H 01 L 21/60, H 01 L 23/48**

(54) **Montage en boîtier pressé de composants de puissance à structure d'électrodes ramifiée.**

(30) Priorité : 02.12.81 FR 8122588

(43) Date de publication de la demande :
08.06.83 Bulletin 83/23

(45) Mention de la délivrance du brevet :
07.05.86 Bulletin 86/19

(84) Etats contractants désignés :
**CH DE FR GB IT LI**

(56) Documents cités :
**DE-A- 2 601 131
FR-A- 1 532 176
FR-A- 2 378 354**

(73) Titulaire : **LE SILICIUM SEMICONDUCTEUR SSC
101, Boulevard Murat
F-75016 Paris (FR)**

(72) Inventeur : **Arnould, Jacques
THOMSON-CSF SCPI 173, bld Haussmann
F-75379 Paris Cedex 08 (FR)**

(74) Mandataire : **Guérin, Michel et al
THOMSON-CSF SCPI 19, avenue de Messine
F-75008 Paris (FR)**

## Description

La présente invention concerne le montage en boîtier pressé de composants de puissance tels que des transistors, des thyristors de divers types, des triacs, etc...

De façon classique, et essentiellement en ce qui concerne les thyristors, les composants de puissance sont montés en boîtier pressé : la tranche semiconductrice, couramment du silicium, constituant le composant de puissance est disposée entre deux électrodes conductrices de l'électricité et de la chaleur, par exemple en cuivre, sans soudure ; et une pression est appliquée par l'intermédiaire de ces blocs de cuivre contre le composant semiconducteur pour assurer la conduction électrique avec les électrodes présentes sur chacune des faces du composant et permettre une bonne dissipation thermique. Généralement, l'une des faces du composant semiconducteur ne comporte qu'une électrode (le collecteur d'un transistor ou l'anode d'un thyristor) et est uniformément métallisée. Contre cette face est généralement alliée ou brasée une contre-électrode intermédiaire en un matériau de coefficient de dilatation proche de celui du silicium, par exemple du molybdène ou du tungstène. L'autre face du composant, dans le cas d'un thyristor, comprend les électrodes de gâchette et de cathode, la métallisation de gâchette étant de petite dimension par rapport à celle de cathode. Une contre-électrode, également en molybdène ou tungstène, peut aussi être appliquée contre cette face supérieure en laissant un passage pour accéder à la gâchette.

Ainsi, des montages pressés ont donné dans l'art antérieur des résultats très satisfaisants quand l'électrode de face supérieure avait une surface relativement importante. Récemment, l'on est de plus en plus tenté d'utiliser des montages pressés pour des composants à semiconducteurs, par exemple transistors ou thyristors sensibles ou thyristors à ouverture par la gâchette, dans lesquels, sur une face du dispositif, une électrode de puissance a une forme ramifiée interdigitée avec une électrode de commande. Mais, une difficulté se présente pour prendre des contacts pressés sur une zone très ramifiée sans établir de court-circuit avec une zone voisine. Pour cela, on a imaginé de former l'une des surfaces ramifiées en relief par rapport à l'autre.

Une première tentative, décrite dans la demande de brevet français 2 378 354, a consisté à déposer par sérigraphie sur l'une des électrodes une couche d'argent. Une deuxième tentative, décrite dans la demande de brevet américain 4 035 831, a consisté à prévoir des creusements de la surface du silicium pour créer une différence de niveau. Dans ces deux cas, comme dans le cas classique où la surface à contacter par pression n'est pas ramifiée, on prévoit, pour éviter les contraintes de dilatation différentielle entre les contacts métalliques et le bloc de cuivre qui vient presser sur ces contacts, une feuille d'un métal de coefficient de dilatation adapté à celui du silicium, par exemple du molybdène et du tungstène (comme d'ailleurs sur l'autre face du composant de puissance).

Une autre tentative a consisté à ne pas créer de différence de niveau entre les contacts sur le silicium du composant mais à donner à la feuille de molybdène ou de tungstène, placée entre l'électrode de puissance ramifiée et le bloc de cuivre, la conformation d'une grille de forme adaptée à celle de l'électrode ramifiée. Néanmoins, dans la pratique, il s'est avéré que de tels dispositifs présentaient une mauvaise durée de vie et une mauvaise résistance à des cyclages thermiques.

Un objet de la présente invention est d'améliorer cet état de choses et de prévoir un montage en boîtier pressé de composant de puissance à structure d'électrodes ramifiée permettant une bonne résistance à des cyclages thermiques.

Pour atteindre cet objet ainsi que d'autres, la présente invention prévoit, conformément à la revendication 1, un montage en boîtier pressé de composants de puissance à structure d'électrodes ramifiée dans lequel le composant de puissance est pressé entre des blocs d'un métal bon conducteur thermique, au moins une grille d'un métal de coefficient de dilatation adapté à celui du semiconducteur constituant le composant étant disposée sur la ou les électrodes ramifiées à la face supérieure du composant, et dans lequel une feuille d'un métal de coefficient de dilatation adapté à celui du semiconducteur est disposée entre la ou les grilles ramifiées et le bloc de métal supérieur. Si le composant semiconducteur est à base de silicium, les métaux à coefficient de dilatation adapté pourront être du molybdène ou du tungstène. Le métal bon conducteur thermique pourra être du cuivre.

La présente invention s'applique notamment aux transistors de puissance, thyristors, triacs, thyristors ouvrables par la gâchette, thyristors à ouverture assistée par la gâchette, etc...

Ces objets, caractéristiques et avantages ainsi que d'autres de la présente invention seront illustrés plus en détail dans la description suivante d'un mode de réalisation particulier faite en relation avec les figures jointes parmi lesquelles :

les figures 1 et 2 représentent respectivement une vue de dessus et une vue en coupe partielle d'un composant semiconducteur de puissance et de son montage en boîtier pressé,

les figures 3 et 4 représentent les modifications selon la présente invention à la structure de la figure 2.

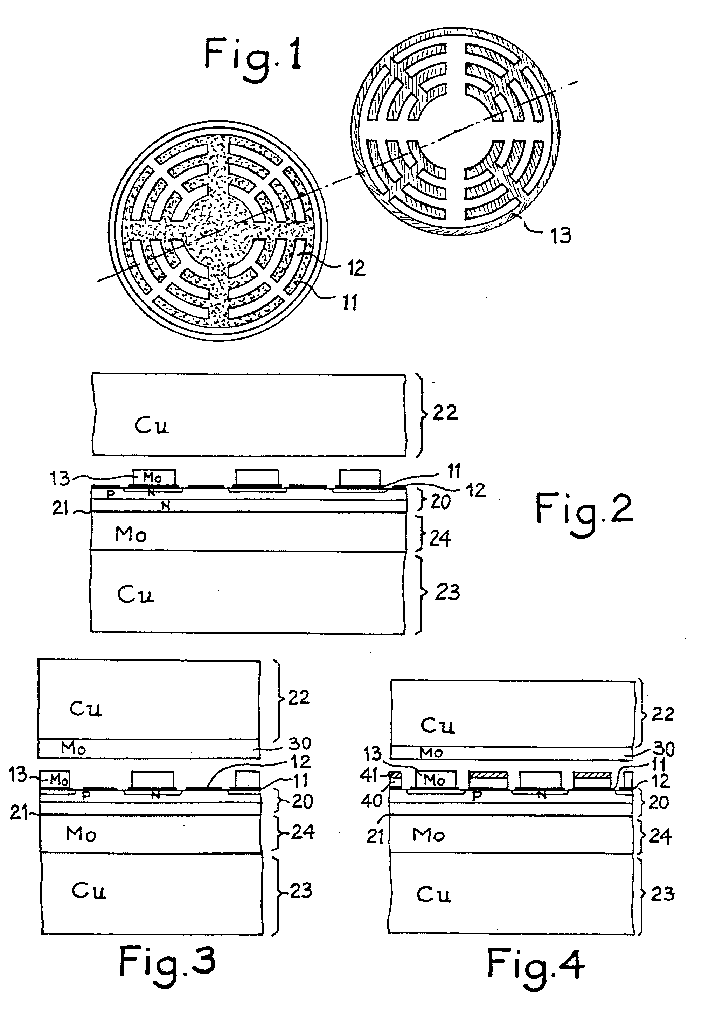

La figure 1 représente une vue de dessus d'un composant de puissance, par exemple un transistor de puissance dont la face inférieure (non visible) comporte une métallisation de collecteur uniforme, et dont la face supérieure comprend deux métallisations ramifiées et interdigitées de façon complémentaire : une métallisation d'émetteur 11 et une métallisation de base 12. Sur la métallisation d'émetteur est posée une grille de molybdène 13 et éventuellement une grille complémentaire interdigitée est posée sur la métallisation de base, la partie supérieure de cette grille complémentaire de base servant de contre-électrode étant recouverte d'une substance isolante pour qu'il n'y ait pas court-circuit entre émetteur et base lors de l'appui ultérieur de la pièce conductrice thermique et électrique contre laquelle va être pressée cette face supérieure.

La figure 2 représente une vue en coupe partielle très agrandie d'une portion du composant de puissance de la figure 1 monté de façon classique en montage pressé. Dans cette figure, comme d'ailleurs dans les autres figures, conformément à l'usage dans le domaine des semiconducteurs, aucune échelle n'est respectée, les épaisseurs et les largeurs des différents éléments étant arbitrairement dilatées ou contractées pour simplifier la lisibilité.

On peut voir dans cette figure 2 la tranche semiconductrice 20 recouverte, sur sa face inférieure, d'une métallisation 21 de collecteur et, sur sa face supérieure, de métallisations complémentaires d'émetteur 11 et de base 12. Les métallisations d'émetteur 11 sont recouvertes d'une grille de molybdène ou de tungstène 13 de configuration correspondant à celle des métallisations 11. Ensuite, le dispositif est pressé entre deux blocs de cuivre 22 et 23. Souvent, on préférera monter la tranche semiconductrice 20, par sa face inférieure, sur une contre-électrode de molybdène 24 alliée ou brasée à cette pastille de silicium.

Or, il s'avère que des dispositifs classiques, tel que celui représenté en figure 2, présentent une mauvaise durée de vie en cas de cyclages thermiques répétés. De l'avis de la demanderesse, ceci est dû au fait que, à la suite de la pression appliquée contre la grille de molybdène 13 par le bloc de cuivre 22, la grille tend à s'encastrer dans le bloc de cuivre. Il en résulte plusieurs inconvénients. D'une part, la pression est suffisamment forte pour que le cuivre dépasse sa limite élastique et la pression appliquée contre le composant n'est plus constante et n'est plus celle que l'on avait choisie initialement. D'autre part, lors de dilatations thermiques du cuivre, celui-ci entraîne en raison de l'effet d'encastrement les doigts de la grille et tend à faire glisser ces doigts contre la surface de la pastille semiconductrice et, ainsi, à détruire des métallisations intermédiaires, couramment des métallisations d'aluminium.

Pour pallier ces inconvénients, la demanderesse propose, comme cela est illustré en figure 3, d'insérer une feuille de molybdène 30 entre la grille 13 servant de contre-électrode et le globe supérieur 22. Ainsi, il n'y a plus d'encastrement de la grille et le glissement éventuel se fait entre la feuille de molybdène 30 et le cuivre 22 lors de dilatations latérales éventuelles de ce bloc de cuivre.

Une autre solution proposée par la présente invention, pour résoudre le problème de mauvaise durée de vie des composants à électrodes ramifiées en montage pressé et qui peut être utilisée complémentairement par rapport à la solution précédemment énoncée qui consiste à prévoir une feuille 30 de coefficient de dilatation adapté par rapport à celui du semiconducteur constituant le composant de puissance, consiste à prévoir une deuxième grille servant de contre-électrode de base (dans le cas d'un transistor) ou de gâchette (dans le cas d'un thyristor) complémentaire de la contre-électrode 13. Cette deuxième contre-électrode 40, comme le montre la figure 4, sera un peu moins épaisse que la première et revêtue à sa surface supérieure d'une couche isolante 41 pour ne pas faire court-circuit avec la première grille 13 par l'intermédiaire du bloc 22 ou de la feuille 30 dans le cas où une telle feuille est prévue. Cette solution permet une répartition plus uniforme des pressions entre les grilles et l'électrode supérieure et permet également de résoudre un autre problème lié aux montages pressés, à savoir une répartition équipotentielle des tensions sur l'électrode de base, cette répartition équipotentielle étant assurée par l'épaisseur de la grille de tungstène ou de molybdène. Ce montage à double grille favorise également la dissipation thermique. Au lieu de prévoir deux épaisseurs différentes pour les grilles d'émetteur et de base, on pourra prévoir que la grille d'émetteur 13 repose sur une métallisation 11 plus épaisse que la métallisation de base 12.

A titre d'exemple dimensionnel, dans la figure 3 on peut considérer que le composant semiconducteur 20 a un diamètre de l'ordre de 20 à 50 mm et une épaisseur de l'ordre de 300 à 500 μm. La grille de molybdène 13 a une épaisseur de l'ordre du millimètre ; la plaque de molybdène 24 a une épaisseur de l'ordre de quelques millimètres ; les blocs de cuivre 22 ont une épaisseur de l'ordre de 0,5 à 1 centimètre. La feuille de molybdène 30 a une épaisseur de l'ordre du millimètre.

La présente invention n'est pas limitée aux modes de réalisation qui ont été explicitement décrits ; bien au contraire, elle englobe les variantes et généralisations incluses dans le champ des revendications ci-après.

## Revendications

1. Montage en boîtier pressé d'un composant semiconducteur de puissance dans lequel le composant de puissance (20), comportant sur une face au moins une métallisation d'électrode de puissance (11) et une métallisation d'électrode de commande (12), ramifiées et interdigitées de façon complémentaire, et pressé entre des blocs inférieur et supérieur (22, 23) d'un métal bon conducteur thermique, une grille (13), découpée dans une feuille d'un métal tel que le molybdène ou le tungstène, dont le coefficient de dilatation est adapté à celui du matériau semiconducteur constituant ledit composant (20), étant disposée sur l'électrode de puissance (11) sur la face du composant (20), ce montage étant caractérisé en ce qu'une feuille (30) de métal ayant même coefficient de dilatation que le métal dans lequel est découpée la grille (13) est interposée entre la grille (13) et le bloc métallique supérieur (22).

2. Montage selon la revendication 1, caractérisé en ce que la grille (13) étant découpée dans une feuille de molybdène, la feuille interposée (30) est une feuille de molybdène.

3. Montage selon la revendication 1, caractérisé en ce que la grille (13) étant découpée dans une feuille de tungstène, la feuille interposée (30) est une feuille de tungstène.

4. Montage selon la revendication 1, caractérisé en ce que le bloc (22) de métal bon conducteur thermique est en cuivre.

5. Montage selon la revendication 1, dans lequel une première grille (13) ramifiée prend un contact de puissance sur une première métallisation d'électrode (11), caractérisé en ce qu'une deuxième grille (40) prend un contact sur une électrode de commande (12), cette deuxième grille (40) étant ramifiée et interdigitée avec la première grille (13), et découpée dans une feuille d'un métal dont le coefficient de dilatation est adapté à celui du matériau semiconducteur du composant (20), cette deuxième grille (40) étant revêtue sur sa partie supérieure d'une couche isolante (41).

**Claims**

1. Mounting of a power semiconductor component in a pressed package wherein the power component (20) is pressed between lower and upper blocks (22, 23) of a metal of good thermal conductivity, said power component comprising on at least one face a power electrode metalization (11) and a control electrode metalization (12) which are branched and interdigitated in complementary fashion, a grid (13) cut from a foil of a metal such as molybdenum or tungsten the expansion coefficient of which is adapted to that of the semiconductor material forming said component (20) being disposed on the power electrode (11) on the face of the component (20), this mounting being characterized in that a foil (30) of a metal having the same expansion coefficient as the metal whereof the grating (13) is cut is interposed between the grating (13) and the upper metallic block (22).

2. Mounting according to claim 1, characterized in that the grating (13) is cut from a molybdenum foil, the interposed foil (30) being a molybdenum foil.

3. Mounting according to claim 1, characterized in that the grating (13) is cut from a tungsten foil and the interposed foil (30) is a tungsten foil.

4. Mounting according to claim 1, characterized in that the block (22) of thermally good conductivity is of copper.

5. Mounting according to claim 1, wherein a first branched grating (13) forms a power contact on a first electrode metallization (11), characterized in that a second grating (40) forms a contact on a control electrode (12), this second grating (40) being branched and interdigitated with the first grating (13) and cut from a foil of a metal the expansion coefficient of which is adapted to that of the semiconductor material of the component (20), this second grating (40) being covered with an insulating layer (41) on its upper portion.

**Patentansprüche**

1. Baueinheit eines Leistungshalbleiterbauteils im Preßgehäuse, bei welcher das Leistungsbauteil (20), welches auf wenigstens einer Fläche eine Metallisierung für die Leistungselektrode (11) und eine Metallisierung für die Steuerelektrode (12) umfaßt, die komplementär verzweigt und interdigital verschachtelt sind, zwischen einem oberen und einem unteren Block (22, 23) aus einem gut wärmeleitenden Metall eingepreßt ist, wobei eine Gitterelektrode (13), welche ausgestanzt ist aus einer Folie eines Metalls wie Molybdän oder Wolfram, dessen Dehnungskoeffizient an den des das Bauteil (20) bildenden Halbleitermaterials angepaßt ist, auf der Leistungselektrode (11) auf der Fläche des Bauteils (20) angeordnet ist, wobei diese Baueinheit dadurch gekennzeichnet ist, daß eine Metallfolie (30), welche denselben Dehnungskoeffizient wie das Metall aufweist, aus dem die Gitterelektrode (13) gestanzt ist, zwischen der Gitterelektrode (13) und dem oberen Metallblock (22) eingefügt ist.

2. Baueinheit nach Anspruch 1, dadurch gekennzeichnet, daß die Gitterelektrode aus einer Molybdänfolie ausgestanzt ist und die zwischengefügte Folie (30) eine Molybdänfolie ist.

3. Baueinheit nach Anspruch 1, dadurch gekennzeichnet, daß die Gitterelektrode (13) aus einer Wolframfolie ausgeschnitten ist und die zwischengefügte Folie (30) eine Wolframfolie ist.

4. Baueinheit nach Anspruch 1, dadurch gekennzeichnet, daß der gut wärmeleitende Metallblock (22) aus Kupfer ist.

5. Baueinheit nach Anspruch 1, bei welcher eine erste verzweigte Gitterelektrode (13) einen Leistungskontakt auf einer ersten Elektrodenmetallisierung (11) bildet, dadurch gekennzeichnet, daß eine zweite Gitterelektrode (40) einen Kontakt auf einer Steuerelektrode (12) bildet, wobei diese zweite Gitterelektrode (40) verzweigt und interdigital mit der ersten Gitterelektrode (13) verschachtelt sowie aus einer Folie eines Metalls ausgeschnitten ist, dessen Dehnungskoeffizient an den des Halbleitermaterials des Bauteils (20) angepaßt ist, wobei diese zweite Gitterelektrode (40) an ihrem oberen Teil mit einer Isolierschicht (41) bedeckt ist.

# Fig.1

13

12

11

# Fig.2

Cu — 22

13 — Mo — 11
P  N — 12
21 — N — 20
Mo — 24
Cu — 23

# Fig.3

Cu — 22
Mo — 30
13 — Mo — 12
P  N — 11
21 — 20
Mo — 24
Cu — 23

# Fig.4

Cu — 22
Mo — 30
13 — 11
41 — Mo — 12
40 — P  N — 20
21 — Mo — 24
Cu — 23